# EUROPÄISCHE PATENTSCHRIFT

(11) **EP 2 612 375 B1**
(45) Veröffentlichungstag und Bekanntmachung des Hinweises auf die Patenterteilung: **01.10.2014**
(21) Anmeldenummer: 11752171.6
(22) Anmeldetag: 24.08.2011
(51) Int. Cl.: F21V 23/02, F21Y 101/02, H01L 41/107, F21V 7/00

(54) **LEUCHTDIODENANORDNUNG MIT EINEM PIEZO-TRANSFORMATOR**
LIGHT-EMITTING DIODE ARRANGEMENT COMPRISING A PIEZO TRANSFORMER
ENSEMBLE LUMINEUX À DIODE ÉLECTROLUMINESCENTE COMPRENANT UN TRANSFORMATEUR PIÉZOÉLECTRIQUE

(30) Priorität: 03.09.2010 DE 102010036251
(43) Veröffentlichungstag der Anmeldung: 10.07.2013
(73) Patentinhaber: OSRAM Opto Semiconductors GmbH, 93055 Regensburg (DE)
(72) Erfinder: RODE, Patrick, 93059 Regensburg (DE); VON MALM, Norwin, 93152 Nittendorf - Thumhausen (DE); HÖPPEL, Lutz, 93087 Alteglofsheim (DE)
(74) Vertreter: Epping - Hermann - Fischer
(86) Internationale Anmeldenummer: PCT/EP2011/064550
(87) Internationale Veröffentlichungsnummer: WO 2012/028509

(56) Entgegenhaltungen:
- EP-A2- 1 729 059
- WO-A1-2010/097407

## Beschreibung

Die vorliegende Anmeldung betrifft eine Leuchtdiodenanordnung mit einem Piezo-Transformator. Mittels des Piezo-Transformators kann eine verfügbare Versorgungsspannung in eine für den Betrieb einer oder mehrerer Leuchtdiodenchips geeignete Spannung transformiert werden. Eine derartige Leuchtdiodenanordnung mit einem integrierten Piezo-Transformator ermöglicht einen platzsparenden Aufbau.

Eine Leuchtdiodenanordnung mit einem Piezo-Transformator und mehreren Leuchtdioden ist beispielsweise in der Druckschrift WO 2010/097407 A1 beschrieben. Wie in Figur 2 dieser Druckschrift gezeigt ist, können die Leuchtdioden auf einer außen liegenden Oberfläche des Piezo-Transformators angeordnet sein. Hierbei sind die Leuchtdioden mechanischen Belastungen von außen und durch die Oszillation des Piezo-Transformators ausgesetzt.

Eine zu lösende Aufgabe besteht vorliegend darin, eine verbesserte Leuchtdiodenanordnung mit kompaktem Aufbau anzugeben.

Diese Aufgabe wird durch eine Leuchtdiodenanordnung gemäß Patentanspruch 1 gelöst.

Erfindungsgemäß umfasst die Leuchtdiodenanordnung einen rahmenförmigen Piezo-Transformator und ein Leuchtdiodenmodul zur Erzeugung von elektromagnetischer Strahlung, das innerhalb des rahmenförmigen Piezo-Transformators angeordnet ist. Der Piezo-Transformator weist zumindest einen ausgangsseitigen Anschluss auf. Das Leuchtdiodenmodul ist mittels zumindest eines ausgangsseitigen elektrischen Leiters elektrisch an den ausgangsseitigen Anschluss des Piezo-Transformators angeschlossen. Die von dem Leuchtdiodenmodul in Richtung des Piezo-Transformators emittierte Strahlung wird an diesem reflektiert.

Mittels des Piezo-Transformators kann eine Reflektivität von insbesondere mehr als 80 % oder von mehr als 90 %, bevorzugt von mehr als 94 % erreicht werden. Vorzugsweise wird diese Reflektivität für elektromagnetische Strahlung im sichtbaren Spektralbereich erzielt. Diese Reflektivität wird dann insbesondere für die vom Leuchtdiodenmodul in Richtung des Piezo-Transformators emittierte Strahlung erzielt.

Der Piezo-Transformator dient also nicht nur als Spannungs-Transformator, sondern bildet zugleich einen Reflektor. Vorzugsweise lenkt der Piezo-Transformator die von dem Leuchtdiodenmodul emittierte Strahlung, die auf den Piezo-Transformator auftrifft, in einen Hauptabstrahlkegel um.

Unter der rahmenförmigen Gestalt ist insbesondere zu verstehen, dass der Piezo-Transformator einen Durchbruch aufweist, der zumindest teilweise in lateraler Richtung vom Material des Piezo-Transformators umgeben ist. Vorzugsweise ist der Durchbruch vollständig vom Material des Piezo-Transformators umschlossen.

Das Leuchtdiodenmodul der Leuchtdiodenanordnung ist mit Vorteil in diesem Durchbruch angeordnet. Insbesondere wird zumindest ein Teil des Leuchtdiodenmoduls von dem Piezo-Transformator seitlich umschlossen. Somit kann die von dem Leuchtdiodenmodul seitlich emittierte Strahlung in einen vorzugsweise längs des Durchbruchs symmetrisch angeordneten Hauptabstrahlkegel umgelenkt werden.

Gemäß einer bevorzugten Ausführungsform weist der Piezo-Transformator eine drehsymmetrische Form auf. Beispielsweise kann der Piezo-Transformator einen runden Umriss aufweisen. Der Piezo-Transformator kann als Hohlzylinder ausgebildet sein. Es ist jedoch auch denkbar, dass der Piezo-Transformator einen rechteckigen Umriss aufweist.

Der Piezo-Transformator enthält oder besteht aus wenigstens einem keramischen Material. Insbesondere kann der Piezo-Transformator als keramisches Material ein Blei-Zirkonat-Titanat (PZT) enthalten. Ferner ist es möglich, dass der Piezo-Transformator frei von Schwermetallen ist. Piezo-Transformatoren sind beispielsweise in den Druckschriften WO 2010/097407 A1 und US 2007/0024254 A1 beschrieben.

An dem mindestens einen ausgangsseitigen Anschluss stellt der Piezo-Transformator elektrischen Strom und Spannung zum Betreiben des Leuchtdiodenmoduls zur Verfügung. Der Piezo-Transformator kann dabei mehr als eine ausgangseitige Anschlussstelle umfassen.

Gemäß einer vorteilhaften Weiterbildung weist der Piezo-Transformator an einer dem Leuchtdiodenmodul zugewandten Oberfläche ein Reflexionsmittel auf zur Reflexion der von dem Leuchtdiodenmodul in Richtung des Piezo-Transformators emittierten Strahlung.

Gemäß einer bevorzugten Ausführungsform ist das Reflexionsmittel zumindest teilweise auf die Oberfläche des beispielsweise keramischen Grundkörpers des Piezo-Transformators aufgebracht. Beispielsweise kann das Reflexionsmittel eine zumindest teilweise auf die Oberfläche des Grundkörpers des Piezo-Transformators aufgebrachte reflektierende Schicht sein.

Bei einer vorteilhaften Ausgestaltung enthält das Reflexionsmittel ein Metall oder eine Metallverbindung. Beispielsweise kann auf die Oberfläche des Grundkörpers des Piezo-Transformators zumindest teilweise eine Beschichtung aufgebracht sein, die ein Metall oder eine Metallverbindung enthält.

Bei einer weiteren Ausgestaltung enthält das Reflexionsmittel ein dielektrisches Material. Insbesondere kann das dielektrische Material ein Siliziumoxid und/oder ein Titanoxid oder eine Kombination dieser oder weiterer dielektrischer Materialien sein. Beispielsweise kann das dielektrische Material oder die Kombination dielektrischer Materialien als Beschichtung(en) zumindest teilweise auf die Oberfläche des Grundkörpers des Piezo-Transformators aufgebracht sein.

Ferner ist es möglich, dass das Reflexionsmittel in einem Zwischenraum zwischen dem Grundkörper des Piezo-Transformators und dem Leuchtdiodenmodul angeordnet ist. Insbesondere kann das Reflexionsmittel diesen Zwischenraum ausfüllen.

Gemäß einer vorteilhaften Ausgestaltung ist das Reflexionsmittel ein reflektierendes Vergussmaterial. Bei dem reflektierenden Vergussmaterial handelt es sich bevorzugt um ein Polymer, in das reflektierend wirkende Partikel eingefüllt sind. Das Polymer des Vergussmaterials, das eine Matrix für die Partikel bildet, ist zum Beispiel ein Silikon, ein Epoxid oder ein Silikon-Epoxid-Hybridmaterial. Die reflektierenden Partikel sind zum Beispiel aus einem Metalloxid wie Aluminiumoxid oder Titanoxid, aus einem Metallfluorid wie Calciumfluorid oder aus einem Siliziumoxid hergestellt oder bestehen daraus.

Beispielsweise kann der Zwischenraum zwischen dem Grundkörper des Piezo-Transformators und dem Leuchtdiodenmodul mit einem reflektierenden Vergussmaterial derart ausgefüllt sein, dass das Leuchtdiodenmodul von dem reflektierenden Vergussmaterial zumindest seitlich umschlossen ist. Somit kann das Leuchtdiodenmodul durch das reflektierende Vergussmaterial geschützt sein.

Gemäß einer vorteilhaften Ausführungsform weist die Leuchtdiodenanordnung einen Hauptanschlussträger mit einer Montagefläche auf, worauf das Leuchtdiodenmodul und der Piezo-Transformator angeordnet sind. Bei dem Hauptanschlussträger handelt es sich beispielsweise um eine Leiterplatte wie eine bedruckte Leiterplatte oder eine Metallkernplatine. Der Hauptanschlussträger umfasst beispielsweise einen elektrisch isolierenden Grundkörper. In und/oder auf den isolierenden Grundkörper sind Leiterbahnen und/oder elektrische Kontaktstellen strukturiert. Ferner weist die Montagefläche mit Vorteil einen reflektierenden Teilbereich auf, worauf das Leuchtdiodenmodul angeordnet ist. Die von dem Leuchtdiodenmodul in Richtung der Montagefläche abgegebene Strahlung kann mittels des reflektierenden Teilbereichs in den Hauptabstrahlkegel umgelenkt werden. Dadurch kann die Strahlungsleistung der Leuchtdiodenanordnung verbessert werden.

Bei einer bevorzugten Weiterbildung weist die Leuchtdiodenanordnung mindestens ein schwingungsdämpfendes Verbindungselement auf. Vorteilhafterweise kann mittels des schwingungsdämpfenden Verbindungselements einer Übertragung der Oszillation des Piezo-Transformators auf andere Elemente der Leuchtdiodenanordnung entgegengewirkt werden.

Gemäß einer weiteren Ausführungsform ist der Piezo-Transformator durch das schwingungsdämpfende Verbindungselement an dem Hauptanschlussträger befestigt. Dadurch kann einer Übertragung der Oszillation des Piezo-Transformators auf den Hauptanschlussträger entgegengewirkt werden.

Vorzugsweise wird der Piezo-Transformator nur durch ein oder mehrere schwingungsdämpfende Verbindungselemente am Hauptanschlussträger gehalten, das heißt ein weiteres Befestigungsmittel ist nicht vorgesehen. Somit ist der Piezo-Transformator von dem Hauptanschlussträger weitgehend mechanisch entkoppelt. Auf diese Weise kann mechanischen Beschädigungen am Piezo-Transformator oder am Hauptanschlussträger vorgebeugt werden.

Die Leuchtdiodenanordnung weist bevorzugt mindestens einen eingangsseitigen elektrischen Leiter auf, mittels welchem der Piezo-Transformator an mindestens einem eingangsseitigen Anschluss elektrisch angeschlossen ist. Typischerweise liegt am eingangsseitigen Anschluss des Piezo-Transformators die Netzspannung an.

Gemäß einer bevorzugten Ausführungsform bildet das mindestens eine schwingungsdämpfende Verbindungselement den mindestens einen eingangsseitigen elektrischen Leiter, mittels welchem der Piezo-Transformator an dem eingangsseitigen Anschluss elektrisch angeschlossen ist. Zweckmäßigerweise enthält das schwingungsdämpfende Verbindungselement hierbei ein elektrisch leitendes Material.

Mit Vorteil enthält das mindestens eine schwingungsdämpfende Verbindungselement ein Metall oder eine Metallverbindung. Beispielsweise kann das mindestens eine schwingungsdämpfende Verbindungselement Gold enthalten oder aus Gold bestehen.

Vorzugsweise ist das mindestens eine schwingungsdämpfende Verbindungselement am einen Ende an einer äußeren Oberfläche des Piezo-Transformators angebracht und am anderen Ende an der Montagefläche des Hauptanschlussträgers befestigt.

Bei einer vorteilhaften Ausgestaltung ist das Leuchtdiodenmodul durch mindestens ein schwingungsdämpfendes Verbindungselement mit dem Piezo-Transformator mechanisch verbunden. Somit kann einer Schwingungsübertragung vom Piezo-Transformator zum Leuchtdiodenmodul entgegengewirkt und eine mechanische Belastung des Leuchtdiodenmoduls durch die Oszillation des Piezo-Transformators verringert werden.

Vorzugsweise bildet das mindestens eine schwingungsdämpfende Verbindungselement zwischen dem Piezo-Transformator und dem Leuchtdiodenmodul den mindestens einen ausgangsseitigen elektrischen Leiter, mittels welchem das Leuchtdiodenmodul elektrisch an den ausgangsseitigen Anschluss des Piezo-Transformators angeschlossen ist.

Neben der Anordnung des Leuchtdiodenmoduls innerhalb des rahmenförmigen Piezo-Transformators trägt auch die doppelte Funktion des Verbindungselements als schwingungsdämpfendes Mittel und elektrischer Leiter zu einer vorteilhaft kompakten Bauweise bei. Gleichzeitig ist das Leuchtdiodenmodul durch den umgebenden rahmenförmigen Piezo-Transformator vor äußeren Einwirkungen und durch das mindestens eine schwingungsdämpfende Verbindungselement vor mechanischen Belastungen vergleichsweise gut geschützt.

Die Leuchtdiodenanordnung ist mit einer geringen Bauhöhe von höchstens 10 mm, insbesondere von höchstens 4 mm, realisierbar.

Das Leuchtdiodenmodul kann zur Erzeugung der elektromagnetischen Strahlung, insbesondere von elektromagnetischer Strahlung im sichtbaren Spektralbereich, mindestens einen Leuchtdiodenchip aufweisen. Hierbei kann es sich um einen handelsüblichen Leuchtdioden-Halbleiterchip handeln, der einen Strahlung erzeugenden aktiven Bereich umfasst und/oder an dem im Betrieb eine Spannung von weniger als 4 V abfällt.

Weiterhin kann der mindestens eine Leuchtdiodenchip ein Hochvolt-Leuchtdiodenchip sein. Bei einem Hochvolt-Leuchtdiodenchip handelt es sich vorliegend um einen Leuchtdiodenchip, der zumindest zwei aktive Bereiche umfasst, die zueinander in Reihe geschaltet sind. Jeder der aktiven Bereiche ist dabei im Betrieb des Hochvolt-Leuchtdiodenchips zur Erzeugung von elektromagnetischer Strahlung vorgesehen. Die aktiven Bereiche können vertikal übereinander gestapelt und/oder lateral nebeneinander angeordnet sein.

Am Hochvolt-Leuchtdiodenchip fällt eine Spannung von wenigstens 4 V ab. Beispielsweise fällt am Hochvolt-Leuchtdiodenchip eine Spannung von 10, 12, 24, 90, 110 oder 230 V ab. Der Hochvolt-Leuchtdiodenchip kann also mit einer relativ hohen Spannung betrieben werden.

Bei einer vorteilhaften Ausgestaltung der Leuchtdiodenanordnung ist der Hochvolt-Leuchtdiodenchip mit Wechselspannung betreibbar. Ein mit Wechselspannung betreibbarer Hochvolt-Leuchtdiodenchip kann beispielsweise dadurch erzielt werden, dass eine erste Gruppe von aktiven Bereichen des Hochvolt-Leuchtdiodenchips zueinander in Reihe geschaltet ist und dass eine zweite Gruppe von aktiven Bereichen des Hochvolt-Leuchtdiodenchips zueinander in Reihe geschaltet ist, wobei die erste Gruppe zur zweiten Gruppe antiparallel geschaltet ist.

Ist der Leuchtdiodenchip des Leuchtdiodenmoduls nicht mit Wechselspannung betreibbar, so umfasst das Leuchtdiodenmodul vorzugsweise wenigstens einen Gleichrichter, der dem Piezo-Transformator vor- oder nachgeschaltet ist.

Der Leuchtdiodenchip kann einfarbige Strahlung oder mischfarbige Strahlung, beispielsweise weißes Licht, emittieren. Umfasst das Leuchtdiodenmodul mehr als einen Leuchtdiodenchip, so können die verschiedenen Leuchtdiodenchips insbesondere Strahlung verschiedener Wellenlänge erzeugen, so dass das Leuchtdiodenmodul insgesamt mischfarbige Strahlung emittiert.

Gemäß einer vorteilhaften Ausgestaltung weist das Leuchtdiodenmodul einen Modulträger mit einer Montagefläche zur Montage des mindestens einen Leuchtdiodenchips auf. Der Leuchtdiodenchip kann als ungehäuster Chip direkt auf die Montagefläche aufgebracht sein. Des Weiteren ist es möglich, dass der Leuchtdiodenchip innerhalb eines Gehäusekörpers angeordnet ist, wobei der Gehäusekörper auf der Montagefläche befestigt ist.

Bei einer bevorzugten Weiterbildung ist die Montagefläche des Modulträgers zumindest teilweise reflektierend ausgebildet. Das heißt der Modulträger weist einen reflektierenden Teilbereich auf. Insbesondere ist der mindestens eine Leuchtdiodenchip auf dem reflektierenden Teilbereich angeordnet. Hierdurch kann die Strahlungsleistung der Leuchtdiodenanordnung verbessert werden.

Gemäß einer bevorzugten Ausführungsform weist die Leuchtdiodenanordnung, insbesondere das Leuchtdiodenmodul, ein optisches Element auf. Besonders bevorzugt ist das optische Element dem mindestens einen Leuchtdiodenchip in Abstrahlrichtung nachgeordnet und lenkt insbesondere zumindest einen Teil der auftreffenden Strahlung in Richtung des Piezo-Transformators um. Das optische Element kann beispielsweise die Lichtauskopplung verbessern, die Lichtverteilung beeinflussen oder zur Lichtbündelung dienen. Zugleich kann das optische Element als Abdeckung und Schutz für den mindestens einen Leuchtdiodenchip dienen. Insbesondere ist das optische Element eine Linse.

Weiterhin umfasst die Leuchtdiodenanordnung vorzugsweise elektronische Komponenten zum Betrieb des Leuchtdiodenmoduls. Die elektronischen Komponenten verteilen sich auf dem Hauptanschlussträger und/oder dem Modulträger.

Mit Vorteil wird die Leuchtdiodenanordnung für verschiedene Beleuchtungssysteme verwendet. Es ist denkbar, die Leuchtdiodenanordnung als Leuchtmittel in einer Deckenleuchte oder Schreibtischlampe zu verwenden. Ferner kann die Leuchtdiodenanordnung als Leuchtmittel an der Unterseite von Möbelstücken, beispielsweise als Unterbauleuchte an einem Hängeschränkchen, Verwendung finden. Durch die geringe Bauhöhe der Leuchtdiodenanordnung lassen sich vergleichsweise flache Beleuchtungssysteme realisieren.

Im Folgenden wird die hier beschriebene Leuchtdiodenanordnung anhand von Ausführungsbeispielen und den dazugehörigen Figuren näher erläutert.
Die Figuren 1 und 2 zeigen in einer schematischen Draufsicht und einer schematischen Seitenansicht ein erstes Ausführungsbeispiel der hier beschriebenen Leuchtdiodenanordnung.
Die Figur 3 zeigt in einer schematischen Seitenansicht ein zweites Ausführungsbeispiel der hier beschriebenen Leuchtdiodenanordnung.
Die Figuren 4, 5 und 6 zeigen schematische Ansichten von verschiedenen Ausführungsbeispielen eines Beleuchtungssystems, welches mindestens eine wie hier beschriebene Leuchtdiodenanordnung aufweist. Gleiche, gleichartige oder gleich wirkende Elemente sind in den Figuren mit denselben Bezugszeichen versehen.

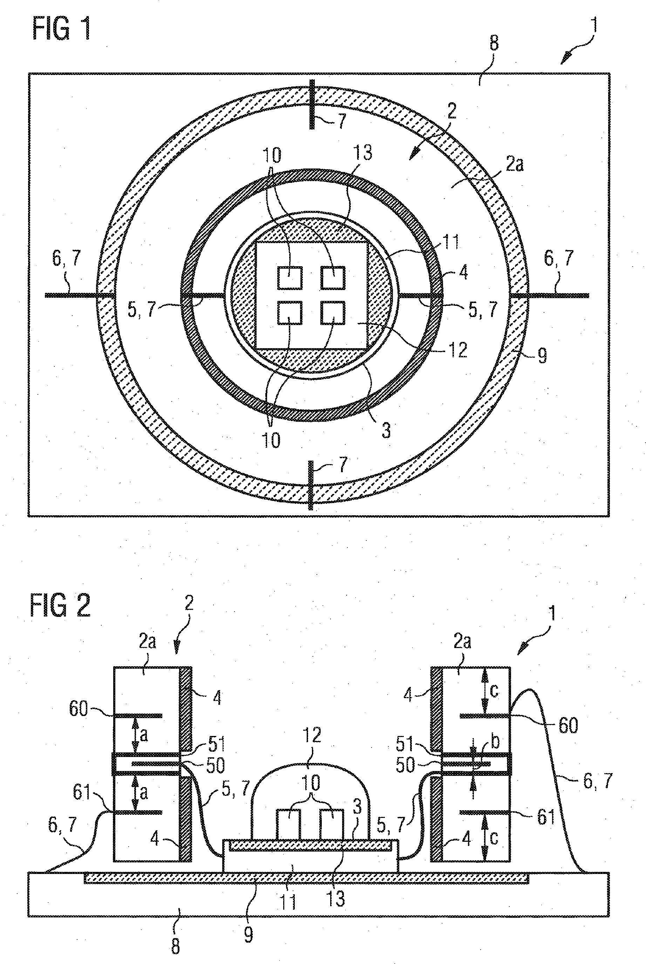

Figur 1 zeigt in Draufsicht eine Leuchtdiodenanordnung 1, die einen rahmenförmigen Piezo-Transformator 2 und ein innerhalb des Piezo-Transformators 2 angeordnetes Leuchtdiodenmodul 3 zur Erzeugung von elektromagnetischer Strahlung umfasst.

Der Piezo-Transformator 2 reflektiert die von dem Leuchtdiodenmodul 3 in Richtung des Piezo-Transformators 2 emittierte Strahlung. Der Piezo-Transformator 2 ist als Hohlzylinder ausgebildet und weist in seinem Inneren einen Durchbruch (nicht bezeichnet) auf, in welchem das Leuchtdiodenmodul 3 angeordnet ist. Das Leuchtdiodenmodul 3 ist somit vom Piezo-Transformator 2 seitlich vollständig umschlossen. Die vom Leuchtdiodenmodul 3 seitlich emittierte Strahlung trifft hierbei in allen Richtungen auf den Piezo-Transformator 2 auf und kann dadurch reflektiert werden. Insbesondere wird die reflektierte Strahlung mittels des Piezo-Transformators 2 in einen längs des Durchbruchs symmetrisch angeordneten Hauptabstrahlkegel umgelenkt.

Bei dem in Figur 1 dargestellten Ausführungsbeispiel weist der Piezo-Transformator 2 zur Reflexion der auftreffenden Strahlung ein Reflexionsmittel 4 auf. Das Reflexionsmittel 4 ist auf einer dem Leuchtdiodenmodul 3 zugewandten Oberfläche eines Grundkörpers 2a des Piezo-Transformators 2 angeordnet. Insbesondere ist das Reflexionsmittel 4 als Beschichtung ringsum auf die Oberfläche aufgebracht. Das Reflexionsmittel 4 kann ein metallischer Spiegel sein und ein Metall oder eine Metallverbindung enthalten oder daraus bestehen. Ferner kann das Reflexionsmittel 4 ein dielektrischer Spiegel sein und ein dielektrisches Material oder eine Kombination dielektrischer Materialien wie ein Siliziumoxid und/oder ein Titanoxid enthalten oder daraus bestehen.

Mittels des Piezo-Transformators 2 kann eine Reflektivität von insbesondere mehr als 80 % oder von mehr als 90 %, bevorzugt von mehr als 94 % erreicht werden.

Der Grundkörper 2a des Piezo-Transformators 2 kann mit einem wie oben beschriebenen keramischen Material gebildet sein.

Der Piezo-Transformator 2 weist zwei ausgangsseitige elektrische Anschlüsse (50, 51 vergleiche Figur 2) und zwei elektrische Anschlussstellen auf (nicht bezeichnet). An jeder Anschlussstelle ist jeweils ein ausgangsseitiger elektrischer Leiter 5 angeordnet. Mittels der beiden ausgangsseitigen elektrischen Leiter 5 ist das Leuchtdiodenmodul 3 elektrisch an die ausgangsseitigen Anschlüsse des Piezo-Transformators 2 angeschlossen und kann dadurch mit einer geeigneten Spannung und einem geeigneten Strom versorgt werden.

Weiterhin sind die elektrischen Leiter 5 schwingungsdämpfend ausgebildet. Sie dienen als schwingungsdämpfende Verbindungselemente 7 zwischen dem Piezo-Transformator 2 und dem Leuchtdiodenmodul 3. Die beiden elektrischen Leiter 5 sind auf zwei gegenüberliegenden Seiten des Leuchtdiodenmoduls 3 angeordnet.

Mittels der schwingungsdämpfenden Verbindungselemente 7 kann einer Schwingungsübertragung vom Piezo-Transformator 2 zum Leuchtdiodenmodul 3 entgegengewirkt und eine mechanische Belastung des Leuchtdiodenmoduls 3 durch die Oszillation des Piezo-Transformators 2 verringert werden.

Ferner umfasst die in Figur 1 dargestellte Leuchtdiodenanordnung 1 einen Hauptanschlussträger 8 mit einer Montagefläche (nicht bezeichnet), auf welcher das Leuchtdiodenmodul 3 und der Piezo-Transformator 2 angeordnet sind.

Bei dem Hauptanschlussträger 8 handelt es sich beispielsweise um eine Leiterplatte wie eine bedruckte Leiterplatte oder eine Metallkernplatine. Der Hauptanschlussträger 8 umfasst insbesondere elektronische Komponenten (nicht gezeigt) zum Betreiben des Piezo-Transformators 2 und/oder des Leuchtdiödenmoduls 3.

Die Montagefläche des Hauptanschlussträgers 8 weist einen reflektierenden Teilbereich 9 auf, worauf der Piezo-Transformator 2 und das Leuchtdiodenmodul 3 angeordnet sind. Der reflektierende Teilbereich 9 ist an die Form des Piezo-Transformators 2 angepasst und weist einen runden Umriss auf. Die von dem Leuchtdiodenmodul 3 in Richtung der Montagefläche abgegebene Strahlung kann mittels des reflektierenden Teilbereichs 9 in den Hauptabstrahlkegel umgelenkt werden.

Das Leuchtdiodenmodul 3 ist fest auf dem Hauptanschlussträger 8 aufgebracht. Beispielsweise kann das Leuchtdiodenmodul 3 an seiner Unterseite auf den Hauptanschlussträger 8 geklebt oder gebondet sein.

Hingegen ist der Piezo-Transformator 2 durch schwingungsdämpfende Verbindungselemente 7 an dem Hauptanschlussträger 8 befestigt. An seiner Unterseite liegt der Piezo-Transformator 2 vorzugsweise beweglich auf der Montagefläche des Hauptanschlussträgers 8 auf. Bei dem in Figur 1 dargestellten Ausführungsbeispiel der Leuchtdiodenanordnung 1 ist der Piezo-Transformator 2 mittels vier schwingungsdämpfenden Verbindungselementen 7 an dem Hauptanschlussträger 8 befestigt. Diese ermöglichen Schwingungen sowohl in vertikaler Richtung, das heißt senkrecht zum Hauptanschlussträger 8, als auch in radialer Richtung. Die schwingungsdämpfenden Verbindungselemente 7 sind auf verschiedenen Seiten des Leuchtdiodenmoduls 3 angeordnet.

Zwei der schwingungsdämpfenden Verbindungselemente 7 dienen als eingangsseitige elektrische Leiter 6, die an zwei eingangsseitigen Anschlussstellen (nicht bezeichnet) des Piezo-Transformators 2 angeordnet sind. Mittels der eingangsseitigen elektrischen Leiter 6 ist der Piezo-Transformator 2 an zwei eingangsseitigen Anschlüssen (60, 61 vergleiche Figur 2) elektrisch angeschlossen. Typischerweise liegt an den beiden eingangsseitigen Anschlüssen des Piezo-Transformators 2 die Netzspannung, das heißt insbesondere 230 V, an.

Die schwingungsdämpfenden Verbindungselemente 7 sind bei diesem Ausführungsbeispiel mit Vorteil aus einem elektrisch leitenden Material gebildet. Insbesondere enthalten oder bestehen die schwingungsdämpfenden Verbindungselemente 7 aus einem Metall oder einer Metallverbindung. Beispielsweise können die Verbindungselemente 7 aus Gold gebildet sein.

Bei der in Figur 1 dargestellten Leuchtdiodenanordnung 1 weist das Leuchtdiodenmodul 3 mehrere Leuchtdiodenchips 10 zur Erzeugung von elektromagnetischer Strahlung auf. Die Leuchtdiodenchips 10 sind ungehäust, das heißt sie weisen keinen Gehäusekörper auf. Die Leuchtdiodenchips 10 können jeweils mischfarbige Strahlung oder gleichfarbige Strahlung emittieren. Ferner können die Leuchtdiodenchips 10 verschiedenfarbige Strahlung emittieren, so dass die mischfarbige Strahlung insgesamt beispielsweise weißes Licht ergibt.

Die Leuchtdiodenchips 10 können herkömmliche Leuchtdiodenchips oder Hochvolt-Leuchtdiodenchips sein, die mit Gleichspannung oder Wechselspannung betreibbar sind.

Das Leuchtdiodenmodul 3 umfasst einen Modulträger 11 mit einer Montagefläche (nicht bezeichnet), auf welcher die Leuchtdiodenchips 10 aufgebracht sind. Der Modulträger 11 ist an die Form des Piezo-Transformators 2 angepasst und weist ebenfalls einen runden Umriss auf. Die Montagefläche ist in einem Teilbereich 13, wo sich die Leuchtdiodenchips 10 befinden, reflektierend ausgebildet. Dadurch kann die Strahlungsleistung des Leuchtdiodenmoduls 3 verbessert werden.

Weiterhin umfasst das Leuchtdiodenmodul 3 ein optisches Element 12, das den Leuchtdiodenchips 10 in Abstrahlrichtung nachgeordnet ist. Es ist wie die Leuchtdiodenchips 10 im Durchbruch des Piezo-Transformators 2 angeordnet.

Das optische Element 12 lenkt insbesondere zumindest einen Teil der Strahlung in Richtung des Piezo-Transformators 2 um. Ferner kann mittels des optischen Elements 12, das hier als Linse ausgebildet ist, die Strahlung gebündelt werden. Das optische Element 12 bedeckt die Leuchtdiodenchips 10, wobei die Leuchtdiodenchips 10 in das optische Element 12 eingebettet sind, und schützt sie vor äußeren Einwirkungen. Die in der Figur 1 dargestellte Leuchtdiodenanordnung 1 ist in Figur 2 in einer Seitenansicht dargestellt.

Wie in Figur 2 zu sehen ist, weist der Piezo-Transformator 2 zwei eingangsseitige Anschlüsse 60, 61 auf, die an einer äußeren Oberfläche des Grundkörpers 2a des Piezo-Transformators 2 vom Material des Piezo-Transformators 2 unbedeckt sind. An der äußeren Oberfläche sind die beiden eingangsseitigen Anschlüsse 60, 61 jeweils mit einem eingangsseitigen elektrischen Leiter 6, 7 verbunden, so dass der Piezo-Transformator 2 elektrisch versorgt werden kann. Die beiden eingangsseitigen elektrischen Leiter 6, 7 sind weiterhin an der Montagefläche des Hauptanschlussträgers 8 befestigt.

Ferner weist der Piezo-Transformator 2 zwei ausgangsseitige Anschlüsse 50, 51 auf, die an einer inneren, dem Leuchtdiodenmodul 3 zugewandten Oberfläche des Grundkörpers 2a des Piezo-Transformators 2 vom Material des Piezo-Transformators 2 unbedeckt sind. An der inneren Oberfläche sind die beiden ausgangsseitigen Anschlüsse 50, 51 jeweils mit einem ausgangsseitigen elektrischen Leiter 5, 7 verbunden, wobei die beiden ausgangsseitigen elektrischen Leiter 5, 7 zum Leuchtdiodenmodul 3 geführt und mit diesem verbunden sind. Somit kann das Leuchtdiodenmodul 3 mit der von dem Piezo-Transformator 2 umgewandelten Spannung elektrisch versorgt werden.

Die beiden eingangsseitigen elektrischen Anschlüsse 60, 61 sind ober- und unterhalb der beiden ausgangsseitigen Anschlüsse 50, 51 angeordnet. Weiterhin wird der eine ausgangsseitige Anschluss 50 von dem anderen ausgangsseitigen Anschluss 51 eingeklammert.

Wie Figur 2 zeigt, überragt der Piezo-Transformator 2 das Leuchtdiodenmodul 3 in seiner Höhe. Für die Bauhöhe der Leuchtdiodenanordnung 1 ist die Höhe des Piezo-Transformators 2 maßgeblich.

Beispielsweise kann der vertikale Abstand a zwischen jeweils einem eingangsseitigen Anschluss 60, 61 und dem einklammernden ausgangsseitigen Anschluss 51 a = 1 mm sein. Außerdem kann der vertikale Abstand b zwischen dem einklammernden ausgangsseitigen Anschluss 51 und dem eingeklammerten ausgangsseitigen Anschluss 50 b = 0,1 mm sein. Ferner kann der vertikale Abstand c zwischen jeweils einem eingangsseitigen Anschluss 60, 61 und dem Rand des Piezo-Transformators 2 c = 0,95 mm sein. Der Durchmesser des Piezo-Transformators 2 kann zwischen 10 mm und 1 cm betragen.

Das Reflexionsmittel 4 bedeckt die innere Oberfläche des Grundkörpers 2a des Piezo-Transformators 2, wobei ein Teilbereich zur Befestigung der ausgangsseitigen elektrischen Leiter 5, 7 frei bleibt.

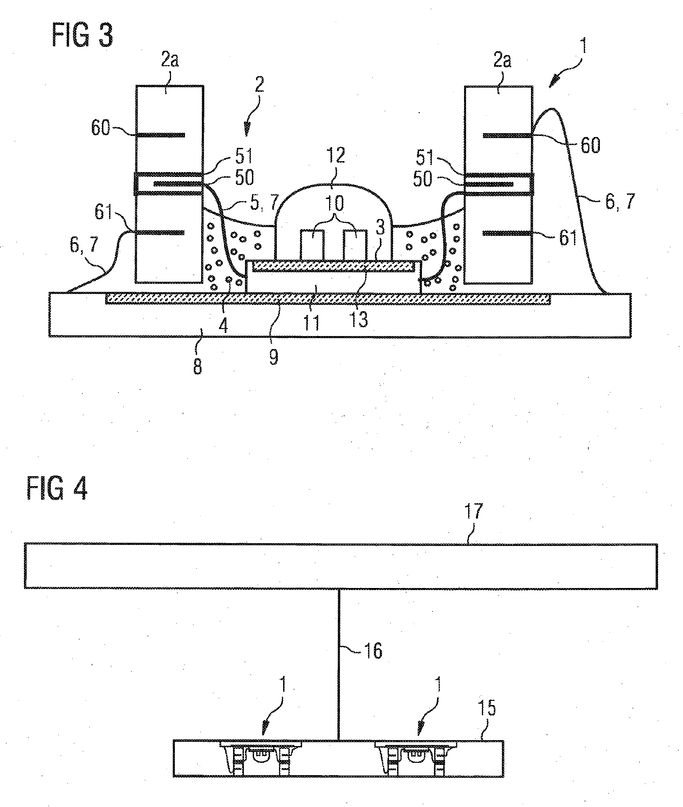

Figur 3 zeigt ein weiteres Ausführungsbeispiel einer bevorzugten Leuchtdiodenanordnung 1. Diese ist bis auf das Reflexionsmittel 4 wie die in den Figuren 1 und 2 dargestellte Leuchtdiodenanordnung 1 aufgebaut. Allerdings ist das Reflexionsmittel 4 in diesem Fall keine reflektierende Beschichtung, sondern ein reflektierendes Vergussmaterial, das in einem Zwischenraum zwischen dem Grundkörper 2a des Piezo-Transformators 2 und dem Leuchtdiodenmodul 3 angeordnet ist. Seitlich umschließt das Reflexionsmittel 4 das Leuchtdiodenmodul 3 und reicht bis zur inneren Oberfläche des Piezo-Transformators 2 heran.

Das Vergussmaterial ist ein Polymer, in das reflektierend wirkende Partikel eingefüllt sind. Das Polymer des Vergussmaterials, das eine Matrix für die Partikel bildet, ist zum Beispiel ein Silikon, ein Epoxid oder ein Silikon-Epoxid-Hybridmaterial. Die reflektierenden Partikel sind zum Beispiel aus einem Metalloxid wie Aluminiumoxid oder Titanoxid, aus einem Metallfluorid wie Calciumfluorid oder aus einem Siliziumoxid hergestellt oder bestehen daraus. Das Vergussmaterial reflektiert diffus. Für einen Betrachter erscheint das Vergussmaterial insbesondere weiß.

Alternativ oder zusätzlich zu einem Reflexionsmittel 4 kann der Grundkörper 2a des Piezo-Transformators 2 selbst reflektierend ausgebildet sein. Dazu können zum Beispiel die oben beschriebenen reflektierenden Partikel in das Material des Grundkörpers 2a eingebracht werden.

In Figur 4 ist ein erstes Ausführungsbeispiel eines Beleuchtungssystems 15 dargestellt. Das Beleuchtungssystem 15 ist eine Deckenleuchte, die als Leuchtmittel zwei der hier beschriebenen Leuchtdiodenanordnungen 1 aufweist. Die Deckenleuchte ist mittels eines Kabels 16, das als Aufhängung dient, an einer Decke 17 befestigt. Die Abstrahlung der Leuchtdiodenanordnungen 1 erfolgt nach unten, das heißt weg von der Decke 17. Durch die geringe Bauhöhe der Leuchtdiodenanordnungen 1 kann die Deckenleuchte flach ausgeführt werden.

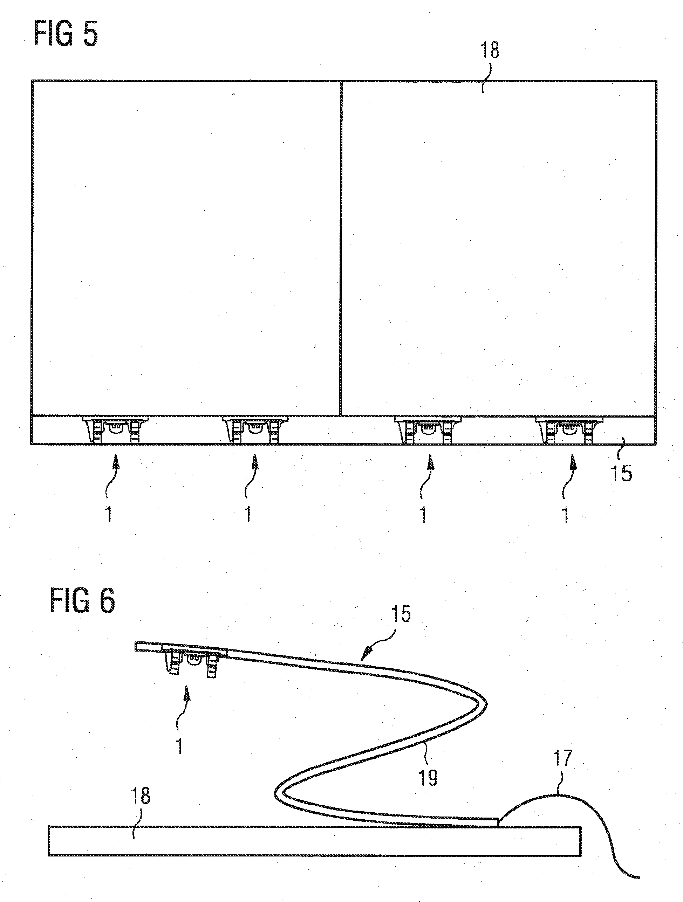

Ein zweites Ausführungsbeispiel eines Beleuchtungssystems 15 ist in Figur 5 dargestellt. Das Beleuchtungssystem 15 ist eine Unterbauleuchte, das an einem Möbelstück 18, beispielsweise einem Hängeschränkchen, angebracht ist und frei in den Raum abstrahlt. Als Leuchtmittel weist das Beleuchtungssystem 15 mehrere Leuchtdiodenanordnungen 1 der hier beschriebenen Art auf. Auch die Unterbauleuchte kann aufgrund der geringen Bauhöhe der Leuchtdiodenanordnungen 1 vorteilhaft flach ausgeführt werden.

Figur 6 zeigt ein drittes Ausführungsbeispiel eines Beleuchtungssystems 15. Hierbei ist das Beleuchtungssystem 15 eine Stehleuchte zur Beleuchtung eines Möbelstücks 18. Beispielsweise ist das Beleuchtungssystem 15 eine Schreibtischleuchte zur Beleuchtung eines Schreibtisches. Als Leuchtmittel kann eine Leuchtdiodenanordnung 1 verwendet werden, die in einem Leuchtenhalter 19 integriert ist. Der Leuchtenhalter 19 kann beispielsweise aus Metall oder Kunststoff gebildet sein. In Verlängerung des Leuchtenhalters 19 ist ein Kabel 17 für den elektrischen Anschluss des Beleuchtungssystems 15 vorgesehen. Bei diesem Ausführungsbeispiel erweist sich nicht nur die geringe Bauhöhe als Vorteil. Auch das geringe Gewicht der Leuchtdiodenanordnung 1, mitverursacht durch das geringe Gewicht des Piezo-Transformators (insbesondere etwa 6 g), ist bei einer Stehleuchte vorteilhaft. Hierdurch kann das Beleuchtungssystem 15 ohne Probleme biegsam ausgeführt sein.

Die hier beschriebene Erfindung ist nicht durch die Beschreibung anhand der Ausführungsbeispiele beschränkt.

## Patentansprüche

1. Leuchtdiodenanordnung (1) mit
- einem rahmenförmigen Piezo-Transformator (2), der zumindest einen ausgangsseitigen Anschluss (50, 51) aufweist,
- einem Leuchtdiodenmodul (3) zur Erzeugung von elektromagnetischer Strahlung, das mittels zumindest eines ausgangsseitigen elektrischen Leiters (5) elektrisch an den ausgangsseitigen Anschluss (50, 51) des Piezo-Transformators (2) angeschlossen ist,
**dadurch gekennzeichnet, dass**
das Leuchtdiodenmodul (3) innerhalb des rahmenförmigen Piezo-Transformators (2) angeordnet ist und dass die von dem Leuchtdiodenmodul (3) in Richtung des Piezo-Transformators (2) emittierte Strahlung an diesem reflektiert wird.

2. Leuchtdiodenanordnung (1) nach Anspruch 1,
wobei der Piezo-Transformator (2) an einer dem Leuchtdiodenmodul (3) zugewandten Oberfläche ein Reflexionsmittel (4) zur Reflexion der von dem Leuchtdiodenmodul (3) in Richtung des Piezo-Transformators (2) emittierten Strahlung aufweist.

3. Leuchtdiodenanordnung (1) nach Anspruch 2,
wobei das Reflexionsmittel (4) ein Metall oder eine Metallverbindung enthält.

4. Leuchtdiodenanordnung (1) nach Anspruch 2,
wobei das Reflexionsmittel (4) ein dielektrisches Material, insbesondere ein Siliziumoxid oder ein Titanoxid, enthält.

5. Leuchtdiodenanordnung (1) nach einem der vorhergehenden Ansprüche,
das einen Hauptanschlussträger (8) mit einer Montagefläche aufweist, auf welcher das Leuchtdiodenmodul (3) und der Piezo-Transformator (2) angeordnet sind.

6. Leuchtdiodenanordnung (1) nach Anspruch 5,
wobei die Montagefläche einen reflektierenden Teilbereich (9) aufweist, auf welchem das Leuchtdiodenmodul (3) angeordnet ist.

7. Leuchtdiodenanordnung (1) nach Anspruch 5 oder 6,
die mindestens ein schwingungsdämpfendes Verbindungselement (7) aufweist.

8. Leuchtdiodenanordnung (1) nach Anspruch 7,
wobei der Piezo-Transformator (2) durch das schwingungsdämpfende Verbindungselement (7) an dem Hauptanschlussträger (8) befestigt ist.

9. Leuchtdiodenanordnung (1) nach einem der vorhergehenden Ansprüche,
die mindestens einen eingangsseitigen elektrischen Leiter (6) aufweist, mittels welchem der Piezo-Transformator (2) an einem eingangsseitigen Anschluss (60, 61) elektrisch angeschlossen ist.

10. Leuchtdiodenanordnung (1) nach Anspruch 8 und 9,
wobei das mindestens eine schwingungsdämpfende Verbindungselement (7) den mindestens einen eingangsseitigen elektrischen Leiter (6) bildet, mittels welchem der Piezo-Transformator (2) an dem eingangsseitigen Anschluss (60, 61) elektrisch angeschlossen ist.

11. Leuchtdiodenanordnung (1) nach einem der vorhergehenden Ansprüche,
wobei das Leuchtdiodenmodul (3) durch mindestens ein schwingungsdämpfendes Verbindungselement (7) mit dem Piezo-Transformator (2) mechanisch verbunden ist.

12. Leuchtdiodenanordnung (1) nach Anspruch 11,
wobei das mindestens eine schwingungsdämpfende Verbindungselement (7) den mindestens einen ausgangsseitigen elektrischen Leiter (5) bildet, mittels welchem das Leuchtdiodenmodul (3) elektrisch an den ausgangsseitigen Anschluss (50, 51) des Piezo-Transformators (2) angeschlossen ist.

13. Leuchtdiodenanordnung (1) nach einem der vorhergehenden Ansprüche,
wobei das Leuchtdiodenmodul (3) einen Modulträger (11) mit einer Montagefläche zur Montage von mindestens einem Leuchtdiodenchip (10) aufweist, die zumindest teilweise reflektierend ausgebildet ist.

14. Leuchtdiodenanordnung (1) nach Anspruch 13,
wobei das Leuchtdiodenmodul (3) ein optisches Element (12) aufweist, das dem Leuchtdiodenchip (10) in Abstrahlrichtung nachgeordnet ist und insbesondere zumindest einen Teil der Strahlung in Richtung des Piezo-Transformators (2) umlenkt.

15. Leuchtdiodenanordnung (1) nach einem der vorhergehenden Ansprüche,
wobei der Piezo-Transformator (2) zumindest einen Teil des Leuchtdiodenmoduls (3) seitlich umschließt.

## Claims

1. Light-emitting diode arrangement (1) comprising
- a frame-shaped piezoelectric transformer (2), which has at least one output-side connection (50, 51),
- a light-emitting diode module (3) for generating electromagnetic radiation, which light-emitting diode module is connected electrically to the output-side connection (50, 51) of the piezoelectric transformer (2) by means of at least one output-side electrical conductor (5),
**characterized in that** the light-emitting diode module (3) is arranged within the frame-shaped piezoelectric transformer (2), and **in that** the radiation emitted by the light-emitting diode module (3) in the direction of the piezoelectric transformer (2) is reflected at said piezoelectric transformer.

2. Light-emitting diode arrangement (1) according to Claim 1, wherein the piezoelectric transformer (2) has, on a surface facing the light-emitting diode module (3), a reflection means (4) for reflecting the radiation emitted by the light-emitting diode module (3) in the direction of the piezoelectric transformer (2).

3. Light-emitting diode arrangement (1) according to Claim 2, wherein the reflection means (4) contains a metal or a metal compound.

4. Light-emitting diode arrangement (1) according to Claim 2, wherein the reflection means (4) contains a dielectric material, in particular a silicon oxide or a titanium oxide.

5. Light-emitting diode arrangement (1) according to one of the preceding claims, which has a main connection carrier (8) comprising a mounting area on which the light-emitting diode module (3) and the piezoelectric transformer (2) are arranged.

6. Light-emitting diode arrangement (1) according to Claim 5, wherein the mounting area has a reflective subregion (9), on which the light-emitting diode module (3) is arranged.

7. Light-emitting diode arrangement (1) according to Claim 5 or 6, which has at least one vibration-damping connecting element (7).

8. Light-emitting diode arrangement (1) according to Claim 7, wherein the piezoelectric transformer (2) is fastened on the main connection carrier (8) via the vibration-damping connecting element (7).

9. Light-emitting diode arrangement (1) according to one of the preceding claims, which has at least one input-side electrical conductor (6), by means of which the piezoelectric transformer (2) is electrically connected to an input-side connection (60, 61).

10. Light-emitting diode arrangement (1) according to Claims 8 and 9, wherein the at least one vibration-damping connecting element (7) forms the at least one input-side electrical conductor (6), by means of which the piezoelectric transformer (2) is electrically connected to the input-side connection (60, 61).

11. Light-emitting diode arrangement (1) according to one of the preceding claims, wherein the light-emitting diode module (3) is mechanically connected to the piezoelectric transformer (2) by at least one vibration-damping connecting element (7).

12. Light-emitting diode arrangement (1) according to Claim 11, wherein the at least one vibration-damping connecting element (7) forms the at least one output-side electrical conductor (5), by means of which the light-emitting diode module (3) is electrically connected to the output-side connection (50, 51) of the piezoelectric transformer (2).

13. Light-emitting diode arrangement (1) according to one of the preceding claims, wherein the light-emitting diode module (3) has a module carrier (11) comprising a mounting area for mounting at least one light-emitting diode chip (10), which mounting area is formed so as to be at least partially reflective.

14. Light-emitting diode arrangement (1) according to Claim 13, wherein the light-emitting diode module (3) has an optical element (12), which is arranged downstream of the light-emitting diode chip (10) in the emission direction and in particular deflects at least some of the radiation in the direction of the piezoelectric transformer (2).

15. Light-emitting diode arrangement (1) according to one of the preceding claims, wherein the piezoelectric transformer (2) laterally surrounds at least part of the light-emitting diode module (3).

## Revendications

1. Arrangement de diodes électroluminescentes (1) comprenant
- un transformateur piézoélectrique (2) en forme de cadre, lequel présente au moins une borne côté sortie (50, 51),
- un module à diodes électroluminescentes (3) destiné à générer un rayonnement électromagnétique, lequel est raccordé électriquement à la borne côté sortie (50, 51) du transformateur piézoélectrique (2) à l'aide d'au moins un conducteur électrique (5) côté sortie,
**caractérisé en ce que**
le module à diodes électroluminescentes (3) est disposé à l'intérieur du transformateur piézoélectrique (2) en forme de cadre et **en ce que** le rayonnement émis par le module à diodes électroluminescentes (3) en direction du transformateur piézoélectrique (2) est réfléchi sur celui-ci.

2. Arrangement de diodes électroluminescentes (1) selon la revendication 1, avec lequel le transformateur piézoélectrique (2) présente, sur une surface faisant face au module à diodes électroluminescentes (3), un moyen de réflexion (4) pour réfléchir le rayonnement émis par le module à diodes électroluminescentes (3) en direction du transformateur piézoélectrique (2).

3. Arrangement de diodes électroluminescentes (1) selon la revendication 2, avec lequel le moyen de réflexion (4) contient un métal ou un composé métallique.

4. Arrangement de diodes électroluminescentes (1) selon la revendication 2, avec lequel le moyen de réflexion (4) contient un matériau diélectrique, notamment un oxyde de silicium ou un oxyde de titane.

5. Arrangement de diodes électroluminescentes (1) selon l'une des revendications précédentes, lequel présente un porte-borne principal (8) muni d'une surface de montage sur laquelle sont disposés le module à diodes électroluminescentes (3) et le transformateur piézoélectrique (2).

6. Arrangement de diodes électroluminescentes (1) selon la revendication 5, avec lequel la surface de montage présente une zone partielle réfléchissante (9) sur laquelle est disposé le module à diodes électroluminescentes (3).

7. Arrangement de diodes électroluminescentes (1) selon la revendication 5 ou 6, lequel présente au moins un élément de liaison (7) amortisseur de vibrations.

8. Arrangement de diodes électroluminescentes (1) selon la revendication 7, avec lequel le transformateur piézoélectrique (2) est fixé au porte-borne principal (8) par l'élément de liaison (7) amortisseur de vibrations.

9. Arrangement de diodes électroluminescentes (1) selon l'une des revendications précédentes, lequel présente au moins un conducteur électrique (6) côté entrée au moyen duquel le transformateur piézoélectrique (2) est raccordé électriquement à une borne côté entrée (60, 61).

10. Arrangement de diodes électroluminescentes (1) selon les revendications 8 et 9, avec lequel l'au moins un élément de liaison (7) amortisseur de vibrations forme l'au moins un conducteur électrique (6) côté entrée au moyen duquel le transformateur piézoélectrique (2) est raccordé électriquement à la borne côté entrée (60, 61).

11. Arrangement de diodes électroluminescentes (1) selon l'une des revendications précédentes, avec lequel le module à diodes électroluminescentes (3) est relié mécaniquement avec le transformateur piézoélectrique (2) par au moins un élément de liaison (7) amortisseur de vibrations.

12. Arrangement de diodes électroluminescentes (1) selon la revendication 11, avec lequel l'au moins un élément de liaison (7) amortisseur de vibrations forme l'au moins un conducteur électrique (5) côté sortie au moyen duquel le module à diodes électroluminescentes (3) est raccordé électriquement à la borne côté sortie (50, 51) du transformateur piézoélectrique (2).

13. Arrangement de diodes électroluminescentes (1) selon l'une des revendications précédentes, avec lequel le module à diodes électroluminescentes (3) présente un porte-module (11) muni d'une surface de montage destinée au montage d'au moins une puce de diode électroluminescente (10), laquelle est configurée au moins partiellement réfléchissante.

14. Arrangement de diodes électroluminescentes (1) selon la revendication 13, avec lequel le module à diodes électroluminescentes (3) présente un élément optique (12) qui est disposé à la suite de la puce de diode électroluminescente (10) dans la direction d'émission du rayonnement et qui dévie notamment au moins une partie du rayonnement en direction du transformateur piézoélectrique (2).

15. Arrangement de diodes électroluminescentes (1) selon l'une des revendications précédentes, avec lequel le transformateur piézoélectrique (2) entoure latéralement au moins une partie du module à diodes électroluminescentes (3).
